(19) Europäisches Patentamt
European Patent Office
Office européen des brevets

(11) **EP 3 804 054 B1**

(12) **EUROPÄISCHE PATENTSCHRIFT**

(45) Veröffentlichungstag und Bekanntmachung des Hinweises auf die Patenterteilung:
**16.04.2025   Patentblatt 2025/16**

(21) Anmeldenummer: **19726958.2**

(22) Anmeldetag: **23.05.2019**

(51) Internationale Patentklassifikation (IPC):
**H01S 5/14** *(2006.01)*          **H01S 5/00** *(2006.01)*
**H01S 5/02216** *(2021.01)*     **H01S 5/02326** *(2021.01)*

(52) Gemeinsame Patentklassifikation (CPC):
**H01S 5/141; H01S 5/02326;** H01S 5/005;
H01S 5/02216

(86) Internationale Anmeldenummer:
**PCT/EP2019/063392**

(87) Internationale Veröffentlichungsnummer:
**WO 2019/224331 (28.11.2019 Gazette 2019/48)**

(54) **LASERDIODEN-ANORDNUNG MIT EINEM EXTERNEN RESONATOR**

LASER DIODE ASSEMBLY HAVING AN EXTERNAL RESONATOR

SYSTÈME DE DIODE LASER POURVU D'UN RÉSONATEUR EXTERNE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.05.2018   DE 102018112561**

(43) Veröffentlichungstag der Anmeldung:
**14.04.2021   Patentblatt 2021/15**

(73) Patentinhaber: **Sacher Lasertechnik GmbH**
**35037 Marburg (DE)**

(72) Erfinder: **SACHER, Joachim**
**35037 Marburg (DE)**

(74) Vertreter: **Patentanwälte Olbricht Buchhold Keulertz**
**Partnerschaft mbB**
**Neue Mainzer Straße 75**
**60311 Frankfurt am Main (DE)**

(56) Entgegenhaltungen:
**US-A- 5 956 355          US-A1- 2006 109 872**
**US-A1- 2010 067 554**

- **JIMÉNEZ A ET AL: "Narrow-line external cavity diode laser micro-packaging in the NIR and MIR spectral range", APPLIED PHYSICS B: LASERS AND OPTICS, SPRINGER INTERNATIONAL, BERLIN, DE, vol. 123, no. 7, 4 July 2017 (2017-07-04), pages 1 - 9, XP036281513, ISSN: 0946-2171, [retrieved on 20170704], DOI: 10.1007/S00340-017-6777-9**

**Beschreibung**

Die Erfindung betrifft eine Laserdioden-Anordnung mit einem externen Resonator gemäß dem Oberbegriff von Anspruch 1.

Laserdioden zeichnen sich durch ihre geringe Größe und Zuverlässigkeit aus. Allerdings lässt sich die Wellenlänge eines durch eine Laserdiode emittierten Laserstrahls durch Beeinflussen einer Laserdiodentemperatur und eines Injektionsstroms nur recht unzuverlässig einstellen. Zudem ist die Linienbreite, also die Bandbreite der Emissionswellenlänge, relativ groß. Die Kopplung einer Laserdiode mit einem externen Resonator ist insbesondere in der optischen Messtechnik weit verbreitet und erlaubt präziser das auch als Durchstimmen bezeichnete Einstellen der gewünschten optischen Eigenschaften.

Ein externer Resonator weist üblicherweise wellenlängenselektive Elemente wie Gitter und Filter auf, die nur Licht bestimmter Wellenlängen - den Resonatormoden - in die Laserdiode zurückkoppeln. Dies führt zu einer Verstärkung der stimulierten Emission auf der jeweils eingestellten Wellenlänge. Gleichzeitig lässt sich über das wellenlängenselektive Element die Emissionswellenlänge über den Verstärkungsbereich der Laserdiode durchstimmen.

Es haben sich insbesondere zwei Anordnungen aus Laserdiode und einem solchen externen Resonator durchgesetzt, die als Littrow- und Littman-Anordnung bekannt sind.

Die Littrow-Anordnung basiert auf der Rückkopplung über ein optisches Beugungsgitter, insbesondere Blaze-Gitter, welches derart orientiert ist, dass die erste Beugungsordnung in die Laserdiode zurückreflektiert wird. Die direkte Reflexion (0. Beugungsordnung) bildet den Auskopplungsstrahl des Lasers. Wird die Ausrichtung des Gitters zu dem emittierten Laserstrahl der Laserdiode beeinflusst, kann die Wellenlänge in einem gewissen Bereich durch Verstärken einer anderen longitudinalen Resonatormode in der Laserdiode geändert werden. Ein Modensprung kann beim Verstimmen dabei über eine geeignete Wahl des Drehpunktes des Beugungsgitters erzielt werden.

In der Littman-Anordnung trifft der von der Laserdiode emittierte Laserstrahl unter einem flachen Winkel auf ein optisches Beugungsgitter, wobei die Beugung erster Ordnung auf einen Resonatorspiegel gelenkt wird. Dieser reflektiert das Licht über das Gitter zurück in die Laserdiode, während die Beugung 0. Ordnung als Nutzstrahl über das Beugungsgitter ausgekoppelt wird. Die Verstimmung der Laserfrequenz erfolgt über eine Drehung des Spiegels. Dabei kann das Verstimmen über eine geeignete Wahl des Drehpunktes des Resonatorspiegels über einen großen Frequenzbereich kontinuierlich modensprungfrei erfolgen.

Es sind weiterhin Diodenlaser mit externem Resonator in Littman-Anordnung nach Iolon bekannt. Hierbei sind allerdings relativ aufwändige Abstimmvorrichtungen vorgesehen, bei denen mittels MEMS-Aktuator eine Bewegung des vorangehend genannten Resonatorspiegels entsprechend einer korrekten Wahl des Drehpunktes erfolgt, so dass ein modensprungfreies Abstimmen der Wellenlänge möglich ist. Neben der kostenintensiven Fertigung kann ein weiterer Nachteil in der geringen Resonanzfrequenz des MEMS-Aktuators gesehen werden, die die Vorrichtung sehr empfindlich gegen Störungen macht.

Auch bei einer Laserdioden-Anordnung mit externem Resonator in Littrow Anordnung nach Schenk wird eine Abstimmvorrichtung mittels MEMS-Aktuator gewählt. Ein bewegbarer Spiegel ist mit Linien entsprechend einem Beugungsgitter strukturiert und ersetzt das Gitter in der klassischen Littrow-Anordnung. Allerdings ist kein modensprungfreies Abstimmen der Wellenlänge möglich.

Aus der DE 10 2014 201 701 A1 ist etwa eine mikromechanisch gefertigte optische Vorrichtung bekannt, bei der eine Platte über eine Auslenkvorrichtung rotatorisch und translatorisch gegenüber einem Träger zum Tragen der Vorrichtung bewegbar ist, wobei die Platte ein Beugungsgitter trägt. Die Kombination dieser beiden Bewegungsarten durch eine Auslenkvorrichtung kann zu einer Störempfindlichkeit der Vorrichtung führen. Zudem ist technisch bei der Translation eine Bewegung von mehreren Millimetern notwendig, die im MEMS-Maßstab nicht realisierbar ist.

Ferner offenbart US 5 956 355 A eine Laserdioden-Anordnung zum Erzeugen einmodiger, durchstimmbarer Laserstrahlung gemäß dem Oberbegriff des Anspruchs 1.

Ziel der Erfindung ist es, diese und weitere Nachteile des Standes der Technik zu überwinden und eine Laserdioden-Anordnung mit einem externen Resonator zu schaffen, welche modensprungfrei durchstimmbar ist, jedoch einen erheblich einfacheren Aufbau als ein MEMS Aktuator von Iolon und eine deutlich höhere Resonanzfrequenz und damit eine geringere Anfälligkeit gegen äußere Störungen aufweist. Angestrebt wird ferner die Erzeugung von einmodigem Laserlicht, dessen Wellenlänge kontinuierlich und frei von Modensprüngen durchstimmbar ist. Der Aufbau soll mit einfachen Mitteln kostengünstig realisierbar und leicht zu handhaben sein.

Hauptmerkmale der Erfindung sind im kennzeichnenden Teil von Anspruch 1 angegeben.

Ausgestaltungen sind Gegenstand der Ansprüche 2 bis 12.

Es wird eine Laserdioden-Anordnung zum Erzeugen einmodiger, durchstimmbarer Laserstrahlung vorgeschlagen, aufweisend eine Laserdiode und einen daran angekoppelten externen Resonator, der einen Resonatorspiegel und mindestens ein wellenlängenselektives optisches Reflexionselement mit einer beugenden Oberfläche aufweist, wobei der Resonatorspiegel um eine Schwenkachse drehbar gelagert ist und mittels einer Auslenkvorrichtung selektiv um die Schwenkachse verdrehbar ist. Die Laserdioden-Anordnung kennzeichnet sich dadurch, dass der externe Resonator dazu ausgebildet ist, dass ein von der Laserdiode in den externen Resonator emittierter Laserstrahl unter einem von der Drehung des Resonatorspiegels abhängigen ersten Einfallswinkel auf eine Spiegelfläche des Resonatorspiegels trifft und von diesem auf das mindestens eine wellenlängenselektive optische Reflexionselement unter einem von dem ersten Einfallswinkel abhängigen zweiten Einfallswinkel reflektiert wird, wobei eine optische Wegstrecke zwischen dem Resonatorspiegel und der beugenden Oberfläche durch den ersten Einfallswinkel beeinflusst wird, und dass das wellenlängenselektive optische Reflexionselement den Laserstrahl zurück auf den Resonatorspiegel reflektiert, so dass er von dem Resonatorspiegel zurück in die Laserdiode geleitet wird, wobei die Wellenlänge des von dem wellenlängenselektiven Reflexionselement reflektierten Laserstrahls durch den zweiten Einfallswinkel beeinflusst wird.

Durch diesen Aufbau ist es möglich, den Fertigungsaufwand deutlich zu reduzieren und gleichzeitig eine geringere Störanfälligkeit zu realisieren, wobei dennoch ein modensprungfreies Durchstimmen über einen großen Frequenzbereich möglich ist. Dies wird insbesondere durch die Anordnung eines Resonatorspiegels an einem dem Resonator zugewandten Ende der Laserdiode ermöglicht, welcher einen von der Laserdiode emittierten Laserstrahl zu dem wellenlängenselektiven Reflexionselement reflektiert. Die beweglichen Teile der Auslenkvorrichtung und des Resonatorspiegels können im Vergleich zu einem mithilfe einer Auslenkvorrichtung rotatorisch und translatorisch bewegbaren Beugungsgitter eine geringere Masse und damit eine deutlich höhere Resonanzfrequenz aufweisen. Zudem ist die rotatorische Lagerung mechanisch deutlich einfacher zu realisieren und erlaubt insbesondere im MEMS-Maßstab eine verbesserte Positionsstabilität. Dies leistet einen hohen Beitrag zur Reduktion der Störanfälligkeit der Abstimmung der Laserdioden-Anordnung gegenüber äußeren Einflüssen. Zudem kann die Ausbildung des wellenlängenselektiven optischen Reflexionselements weitgehend unabhängig von mechanischen Einschränkungen realisiert werden, die für rotatorisch und translatorisch bewegbare Gitter in Betracht zu ziehen sind.

Die Laserdiode kann bevorzugt mit einer Kollimationsoptik ausgestattet sein. Beispielsweise ist im Bereich der Front- und/oder Rückfacette eine optische Transmissionskomponente in Form einer Kollimationslinse angeordnet. Diese sorgt dafür, dass divergent aus der Front- und/oder Rückfacette der Laserdiode austretendes Laserlicht parallelisiert wird. Je nach Verwendung des Laserlichts kann jedoch auch eine andere Optik verwendet werden.

Die durch die Laserdioden-Anordnung erreichte Emissionswellenlänge wird durch zwei Bedingungen bestimmt. Eine erste Bedingung wird nachfolgend als gitterbestimmte Wellenlänge $\lambda_g$ bezeichnet. Diese lässt sich durch die Gleichung

$$n \cdot \lambda_g = g \cdot \sin(\varphi) \qquad \text{(Formel 1)}$$

mit

$\lambda_g$     durch die beugende Oberfläche bestimmte Wellenlänge,
g     Gitterkonstante der beugenden Oberfläche,
$\varphi$     Einfallswinkel auf die beugende Oberfläche und
n     Beugungsordnung, hier erste Ordnung n=1

bestimmen. Die durch die beugende Oberfläche bestimmte Wellenlänge ist folglich direkt von dem Einfallswinkel des von dem Resonatorspiegel reflektierten und auf der beugenden Oberfläche auftreffenden Laserstrahls abhängig.

Die zweite Bedingung ist durch die resonatorbestimmte Wellenlänge $\lambda_R$ zu

$$\lambda_R = 2 \cdot L_R / m \qquad \text{(Formel 2)}$$

mit

$\lambda_R$     Durch eine optische Resonatorlänge $L_R$ bestimmte Wellenlänge
$L_R$     optische Länge des Laserresonators
m     Anzahl der Wellenknoten im Laserresonator

gegeben. Die optische Länge $L_R$ setzt sich aus den Teilstrecken einer optischen Länge der Laserdiode, einer Länge des Laserstrahls zwischen der Laserdiode und dem Resonatorspiegel und einer Länge des Laserstrahls zwischen dem Resonatorspiegel und der beugenden Oberfläche zusammen. Da diese optische Länge zweimal durchlaufen wird, ist in der obigen zweiten Bedingung der Faktor 2 enthalten.

Beim Drehen des Resonatorspiegels um die Schwenkachse ändern sich der Einfallswinkel und der Ausfallswinkel des emittierten Laserstrahls auf dem Resonatorspiegel entsprechend dem Reflexionsgesetz. Hieraus folgt ein sich ändernder Einfallswinkel $\varphi$ auf der beugenden Oberfläche sowie gleichzeitig hieraus eine sich ändernde Länge eines zwischen dem Resonatorspiegel und der beugenden Oberfläche verlaufenden Laserstrahls. Mithilfe lediglich einer einzigen Stellgröße in Form des ersten Einfallswinkels, d.h. in Form einer Drehposition des Resonatorspiegels, werden gleichzeitig die optische Länge des Resonators und die Wellenlänge des in die Laserdiode zurückgeleiteten Laserstrahls beeinflusst.

Wenn sich beim Abstimmen der Laserwellenlänge die Anzahl der Wellenknoten m verändert, so wird von einem Modensprung gesprochen. Ziel der Laserdioden-Anordnung ist eine Abstimmbarkeit der Wellenlänge, ohne dass sich die Anzahl der Wellenlängenknoten verändert. Dieses wird als modensprungfreies Abstimmen der Wellenlänge bezeichnet. Die formale Anforderung hierfür ist

$$| \, 2 \cdot L_R \, / \, \lambda_g - m \, | < \tfrac{1}{2} \qquad \text{(Formel 3)}$$

Letztlich wird durch Anpassen der Resonatorlänge und der durch die beugende Oberfläche bestimmten Wellenlänge diese Bedingung erfüllt. Dies kann erfindungsgemäß durch Rotation des Resonatorspiegels erreicht werden. Bei einer geeigneten Wahl einer Gitterkonstante der beugenden Oberfläche sowie der Resonatorlänge $L_R$ bleibt die Anforderung an modensprungfreies Abstimmen entsprechend obiger Gleichung über den Abstimmbereich des Lasers erfüllt.

Bevorzugt vergrößert sich die optische Wegstrecke zwischen dem Resonatorspiegel und der beugenden Oberfläche mit zunehmendem ersten Einfallswinkel. Der Resonatorspiegel und die beugende Oberfläche sind demzufolge so anzuordnen, dass bei zunehmendem ersten Einfallswinkel ein Treffpunkt des auf die beugende Oberfläche reflektierten Laserstrahls zunehmend weiter von dem Resonatorspiegel beabstandet ist. Die Vergrößerung der optischen Wegstrecke ist dadurch sehr einfach und wird ausschließlich durch eine Rotation des Resonatorspiegels verursacht.

Des Weiteren vergrößert sich bevorzugt die Wellenlänge des von dem wellenlängenselektiven Reflexionselement reflektierten Laserstrahls mit zunehmendem ersten Einfallswinkel. Das wellenlängenselektive Reflexionselement kann etwa derart relativ zu dem Resonatorspiegel angeordnet werden, dass der zweite Einfallswinkel mit zunehmendem ersten Einfallswinkel ebenfalls zunimmt. Die beugende Oberfläche ist dabei dann so anzupassen, dass die Wellenlänge bei zunehmendem zweiten Reflexionswinkel zunimmt.

Bevorzugt sind das wellenlängenselektive Reflexionselement und der Resonatorspiegel so zueinander positioniert, dass die durch Drehung des Resonatorspiegels verursachte Änderung der optischen Wegstrecke zwischen dem Resonatorspiegel und der beugenden Oberfläche sowie die Änderung der Wellenlänge des von dem wellenlängenselektiven Reflexionselements reflektierten Laserstrahls aneinander angepasst sind, dass die Bedingung in der vorangehend angegebenen Formel 3 stets erfüllt wird.

Die Laserdiode weist bevorzugt eine Rückfacette und eine Frontfacette auf. Um den externen Resonator einsetzen zu können, ist die dem externen Resonator zugewandte Frontfacette bevorzugt mit einer Antireflexionsschicht beschichtet, so dass die Eigenmoden der Laserdiode, deren durch ihre Facetten begrenzter Raum ebenso einen Resonator bildet, unterdrückt werden. Folglich weist in einer vorteilhaften Ausführungsform die Laserdiode eine Rückfacette und eine dem externen Resonator zugewandte und mit einer Antireflexionsschicht versehene Frontfacette auf.

In einer vorteilhaften Ausführungsform ist das mindestens eine wellenlängenselektive optische Reflexionselement ein optisches Beugungsgitter. Allgemein kann das Beugungsgitter ein Furchen aufweisendes Reflexionsgitter sein, das dazu vorgesehen ist, Strahlen gebeugt zu reflektieren. Das Beugungsgitter ist bevorzugt so auszubilden, dass einfallende Strahlen senkrecht auf die Furchen auftreffen. Einfallende und reflektierte Lichtstrahlen sind dann stets parallel zueinander ausgerichtet. Das optische Beugungsgitter kann geritzt oder holographisch ausgeführt sein. Insbesondere kann ein geritztes Beugungsgitter als Blaze-Gitter ausgeführt sein.

Die Schwenkachse ist an einer von der Laserdiode abgewandten Seite des Resonatorspiegels in einem Abstand zu der Spiegelfläche positioniert. Die Spiegelfläche wird folglich derart auf einer Kreisbahn verschwenkt, dass die Spiegelfläche auf dieser Kreisbahn radial nach außen gerichtet ist. Der Abstand zwischen der Spiegelfläche und der Schwenkachse könnte bevorzugt jedoch möglichst gering sein, so dass der Bewegungsbereich des auftreffenden Laserstrahls und damit die Spiegelfläche minimiert werden können. Eine solche Anordnung lässt eine einfache und flache Realisierung des Resonators als mikromechanisches Element zu.

Ein Abstand zwischen einer der Schwenkachse des Resonatorspiegels am nächsten gelegenen Linie auf der Spiegelfläche und einem Treffpunkt des gesamten Laserstahls auf der Spiegelfläche ist größer als 0. Bei realen Diodenlasern mit externem Resonator kann sich über den Abstimmbereich der Laserdiode Dispersion zeigen. Es ändert sich folglich der Brechungsindex des Materials der Laserdiode und damit die optische Länge der Laserdiode. Der Einfluss der Dispersion kann durch das Maß des Abstands zwischen einer der Schwenkachse des Resonatorspiegels am nächsten gelegenen Linie auf der Spiegelfläche und dem Treffpunkt des Laserstahls auf der Spiegelfläche kompensiert werden. Mit diesem Abstand wird ein unabhängiger Beitrag höherer Ordnung eingeführt, mit dessen Hilfe durch Anpassung einer von der Drehung des Resonatorspiegels abhängigen Änderung der Resonatorlänge die Dispersion des Lasermaterials kompensiert wird.

Eine vorteilhafte Ausführungsform weist ferner mindestens eine optische Transmissionskomponente zwischen dem Resonatorspiegel und der Laserdiode auf. Dadurch kann insbesondere die Ankopplungsgüte des externen Resonators an die Laserdiode beeinflusst werden.

Es kann sich anbieten, dass die mindestens eine optische Transmissionskomponente einen Kollimator umfasst. Dieser kann aus divergentem Laserlicht ein Parallelstrahlbündel erzeugen, welches auf den Resonatorspiegel trifft.

Weiterhin kann zum Erhalt eines gewünschten Bündels paralleler Lichtstrahlen an einer der Laserdiode abgewandten Seite der Rückfacette ebenso ein Kollimator angeordnet sein. Bevorzugt ist das mindestens eine wellenlängenselektive Reflexionselement schräg zu einer Abstrahlrichtung des von der Laserdiode emittierten Laserstrahls angeordnet. Insbesondere kann die beugende Oberfläche von der Laserdiode abgewandt sein und stets nicht parallel zu der Abstrahlrichtung sein.

Es könnte sich zudem anbieten, den Resonatorspiegel ebenso schräg zu einer Abstrahlrichtung des von der Laserdiode emittierten Laserstrahls anzuordnen, wobei die Spiegelfläche der Laserdiode zugewandt ist.

Der Resonatorspiegel könnte dabei derart bewegbar sein, dass zumindest in einer Position des Resonatorspiegels und des wellenlängenselektiven Reflexionselements der Resonatorspiegel parallel zu dem wellenlängenselektiven Reflexionselement ausgerichtet ist. Der Resonatorspiegel kann folglich einen großen Bereich des wellenlängenselektiven Reflexionselements durch Reflexion von Laserstrahlen durch Verschwenken abdecken.

Die Laserdioden-Anordnung ist bevorzugt als ein mikromechanisches System gefertigt. Die betreffenden Auslenkvorrichtungen können dabei insbesondere als elektrostatische Aktuatoren ausgeführt sein.

Weitere Merkmale, Einzelheiten und Vorteile der Erfindung ergeben sich aus dem Wortlaut der Ansprüche sowie aus der folgenden Beschreibung von Ausführungsbeispielen anhand der Zeichnungen. Es zeigen:

Fig. 1        eine schematische Darstellung einer Laserdioden-Anordnung,

Fig. 2        eine schematische Darstellung eines mikromechanischen Resonatorspiegels,

Fig. 3a bis 3c    schematische Darstellungen der Laserdioden-Anordnung mit unterschiedlichen Drehwinkeln des Resonatorspiegels bei mittiger Schwenkachse des Resonatorspiegels,

Fig. 4a bis 4c    schematische Darstellungen der Laserdioden-Anordnung mit unterschiedlichen Drehwinkeln des Resonatorspiegels bei versetzter Schwenkachse des Resonatorspiegels zur Kompensation von Dispersionseffekten, und

Fig. 5        einen exemplarischen mikromechanischen Aufbau der Laserdioden-Anordnung.

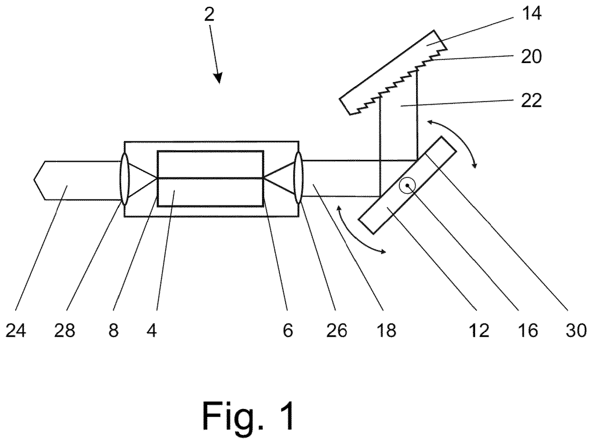

Fig. 1 zeigt schematisch eine Laserdioden-Anordnung 2 mit einem Diodenlaser 4, der eine bevorzugt mit einer Antireflexionsschicht beschichtete Frontfacette 6 und eine als Endspiegel fungierende Rückfacette 8 aufweist. Die Frontfacette 6 ist einem externen Resonator 10 zugewandt, der einen Resonatorspiegel 12 und ein wellenlängenselektives optisches Reflexionselement in Form eines Beugungsgitter 14 aufweist. Der Resonatorspiegel 12 ist um eine Schwenkachse 16 schwenkbar gelagert. Ein von der Laserdiode 4 emittierter Laserstrahl 18 trifft auf den Resonatorspiegel 12 und wird von diesem zu dem Beugungsgitter 14 reflektiert. Eine beugende Oberfläche 20 beugt und reflektiert das eintreffende Licht, so dass eine erste Beugungsordnung 22 den Resonatorspiegel 12 trifft und wieder zurück in die Laserdiode 4 reflektiert wird. Über die Rückfacette 8 wird ein Laserstrahl 24 ausgekoppelt. Zur parallelen Ausrichtung der Laserstrahlen 18 und 24 wird eine Kollimationsoptik mit einem ersten Kollimator in Form einer ersten Kollimationslinse 26 und einem zweiten Kollimator in Form einer zweiten Kollimationslinse 28 eingesetzt.

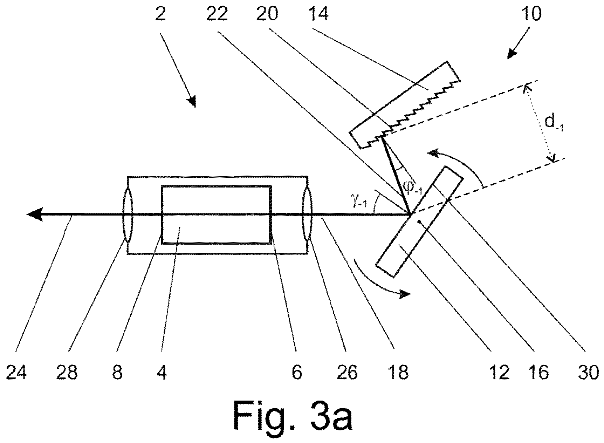

Die bei dieser Anordnung 2 entstehende optische Länge, welche nachfolgend auch als $L_R$ bezeichnet wird, setzt sich aus der Summe der optischen Länge der Laserdiode 4 und der von den Laserstrahlen 18 und 22 zusammen erfahrenen optischen Länge. Die beugende Oberfläche 20 kann in Form eines Blaze-Gitters oder einer anderen Gitterform ausgeführt sein und ist schräg zu dem emittierten Laserstrahl 18 angeordnet. Das Beugungsgitter 14 weist bevorzugt Gitterlinien auf, die parallel zu der Schwenkachse 16 angeordnet sind. Durch Rotation des Resonatorspiegels 12 kann die Richtung des zwischen dem Resonatorspiegel 12 und dem Beugungsgitter 14 verlaufenden Laserstrahls 22 beeinflusst werden. Hierdurch wird neben der von der beugenden Oberfläche 20 bestimmten, von der Einstrahlrichtung abhängigen Wellenlänge ebenso die optische Länge $L_R$ des Resonators beeinflusst. Hierauf wird in der Beschreibung der Figuren 3a bis 4c detaillierter eingegangen.

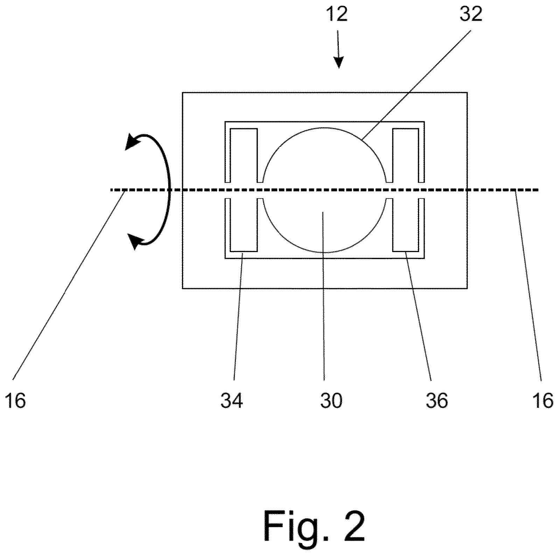

Fig. 2 zeigt eine mikromechanische Ausführung des Resonatorspiegels 12. Eine Spiegelfläche 30 ist auf einer kreisförmigen Fläche 32 ausgebildet, die mit zwei Aktuatorabschnitten 34 und 36 gekoppelt ist. Diese könnten auf einem elektrostatischen Wirkprinzip basieren und eine von einer Eingangsspannung abhängige quasistatische Position in Form einer Rotation um die Schwenkachse 16 durchführen. Der Resonatorspiegel 12 kann insbesondere einstückig und siliziumbasiert hergestellt sein.

Fig. 3a bis 3c zeigen den Einfluss einer Rotation des Resonatorspiegels 12 auf die Abstimmung der Anordnung 2.

Der von der Laserdiode 4 emittierte Laserstrahl 18 trifft in Fig. 3a auf die Spiegelfläche 30 unter einem Einfallswinkel $\gamma_{-1}$, der aufgrund der Reflexion des Laserstrahls 18 zu einem reflektierten Laserstrahl 22 führt, der unter einem Einfallswinkel $\varphi_{-1}$ auf das Beugungsgitter 14 trifft. Die durch das Beugungsgitter 14 generierte Wellenlänge bei erster Beugungsordnung berechnet sich folglich zu $\lambda_g = g \cdot \sin(\varphi_{-1})$.

Durch die Ausrichtung des Beugungsgitters 14 relativ zu dem Resonatorspiegel 12 ergibt sich eine von dem Laserstrahl 22 zu überbrückende optische Wegstrecke bzw. Distanz $d_{-1}$. Beispielhaft ist in Fig. 3a ein der Laserdiode 4 naher Bereich des Beugungsgitters 14 mit einer geringen optischen Wegstrecke $d_{-1}$ betroffen. Die optische Länge $L_R$ des Laserresonators 10 berechnet sich folglich als Summe der optischen Länge der Laserdiode 4, der Länge des zwischen der Laserdiode 4 und dem Resonatorspiegel 12 verlaufenden Laserstrahls 18 und der durch die Drehung des Resonatorspiegels 12 verursachten optischen Wegstrecke $d_{-1}$.

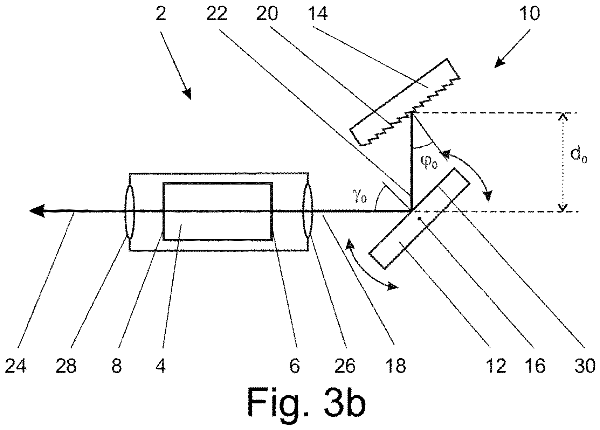

In Fig. 3b ist der Resonatorspiegel 12 in der Zeichnungsebene im Uhrzeigersinn etwas weiter gedreht, so dass beispielhaft ein Einfallswinkel $\gamma_0$ von ca. 45° entsteht. Hierdurch wird das Beugungsgitter 14 exemplarisch mittig getroffen, so dass sich ein Einfallswinkel $\varphi_0$ ergibt. Bei der exemplarischen Konstellation resultiert eine von dem Laserstrahl 22 zu überbrückende optische Wegstrecke bzw. Distanz $d_0$, die größer als $d_{-1}$ ist. Aufgrund des geänderten Einfallswinkels $\gamma_0$ und der größeren optischen Weglänge kann eine stehende Welle mit einer höheren Wellenlänge zwischen der Rückfacette 8 und dem Beugungsgitter 14 erzeugt werden, so dass der ausgekoppelte Laserstrahl 24 als Folge eine geringere Frequenz aufweist als der in Fig. 3a.

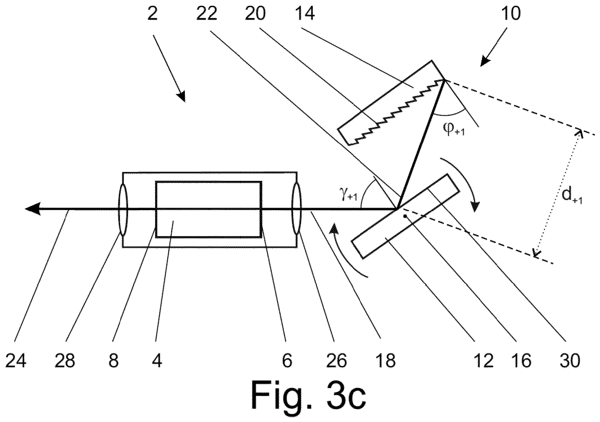

Analog gilt dies für die Darstellung in Fig. 3c. Dort ist der Resonatorspiegel 12 in der Zeichnungsebene im Uhrzeigersinn noch etwas weitergedreht, so dass der Einfallswinkel $\gamma_{+1}$ noch weiter vergrößert wird. Die beugungsabhängige Wellenlänge wird durch den ebenso größeren Einfallswinkel $\varphi_{+1}$ am Beugungsgitter 14 beeinflusst und die optische Wegstrecke bzw. Distanz $d_{+1}$, die größer als $d_0$ und $d_{-1}$ ist, führt zu einer noch höheren Wellenlänge der stehenden Welle zwischen der Rückfacette 8 und dem Beugungsgitter 14 bei gleichbleibenden Schwingungsmoden als in Fig. 3a und 3b. Der ausgekoppelte Laserstrahl 24 kann folglich eine noch geringere Frequenz aufweisen.

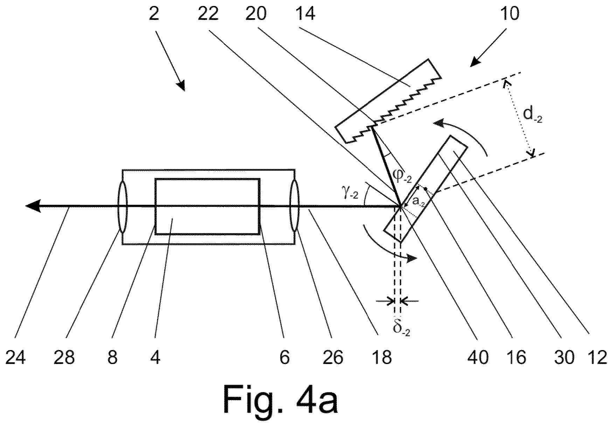

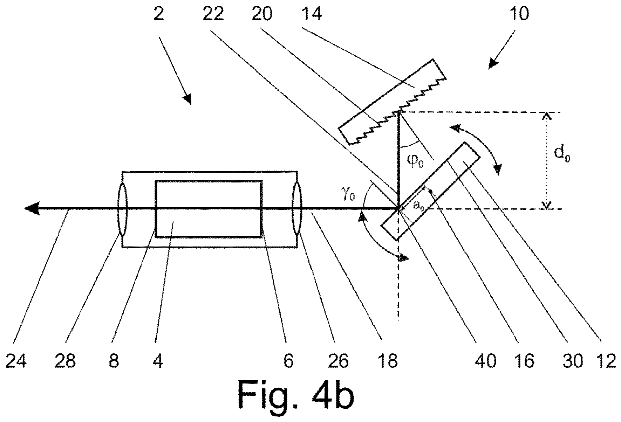

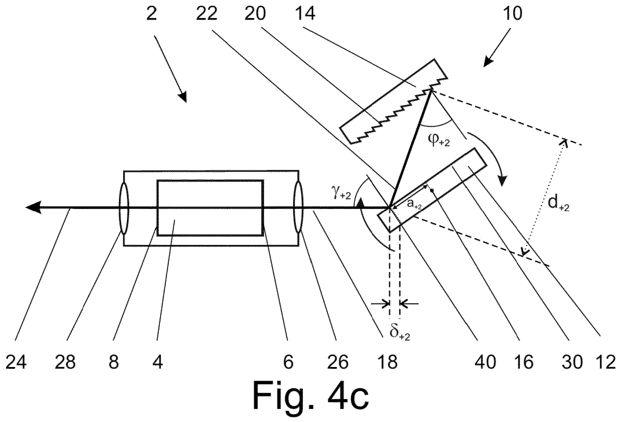

Die Laserdiode 4 kann über den Abstimmbereich Dispersionseffekte zeigen, bei denen sich der Brechungsindex des Materials der Laserdiode 4 und damit die optische Länge der Laserdiode 4 ändern. Wie in den Fig. 4a bis 4c gezeigt können diese Effekte durch geschickte Positionierung der Schwenkachse 16 kompensiert werden.

Die Schwenkachse 16 kann mittig an dem Resonatorspiegel 12 an einer von der Laserdiode 4 abgewandten Seite des Resonatorspiegels 12 angeordnet sein. Beispielhaft ist die Schwenkachse 16 gegenüber der Anordnung in den Fig. 1 und 3a bis 3c so versetzt, dass ein Maß des Abstands zwischen einer der Schwenkachse 16 des Resonatorspiegels am nächsten gelegenen Linie auf der Spiegelfläche 30 und einem Treffpunkt 40 des Laserstahls 18 auf der Spiegelfläche 30 vergrößert wird. Die Schwenkachse 16 ist in der Zeichnungsebene hierfür etwa deutlich oberhalb der durch den Laserstrahl 18 gebildeten Linie angeordnet. Der Laserstrahl 18 trifft dann hauptsächlich auf einen radial außenliegenden, zu der Laserdiode 4 gerichteten Abschnitt des Resonatorspiegels 12. Durch diesen Versatz der Schwenkachse 16 erfolgt eine Änderung der optischen Länge des Laserstrahls 18 zwischen der Frontfacette 6 und dem Resonatorspiegel 12 um einen Betrag $\delta_{-2}$ bzw. $\delta_{+2}$, beim Einnehmen derselben Drehpositionen wie in Fig. 3a bis 3c. Gleichzeitig können sich die Einfallswinkel des Laserstrahls 18 auf den Resonatorspiegel 12 von $\gamma_{-1}$ zu $\gamma_{-2}$ und von $\gamma_{+1}$ zu $\gamma_{+2}$ ändern, was zu geänderten Einfallswinkeln an dem Beugungsgitter 14 von $\varphi_{-1}$ zu $\varphi_{-2}$ und von $\varphi_{+1}$ zu $\varphi_{+2}$ führt. Durch geschickte Anpassung der Position der Schwenkachse 16 kann folglich der Dispersionseffekt der Laserdiode 4 durch kombinierte Beeinflussung von Beugungsparametern und der optischen Länge $L_R$ zwischen der Rückfacette 8 und dem Beugungsgitter 14 ausgeglichen werden.

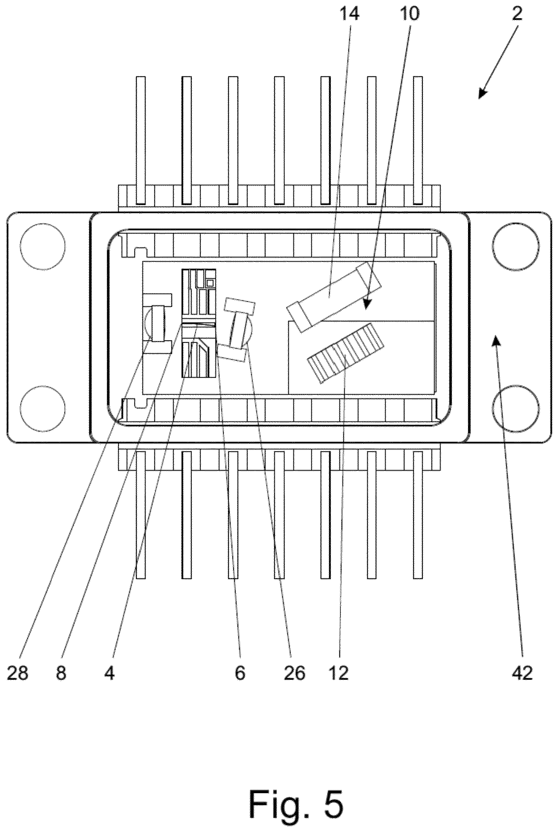

Schließlich zeigt Fig. 5 exemplarisch eine Realisierung der Laserdioden-Anordnung 2 als mikromechanisches System, welches auf einem Träger 42 angeordnet ist.

Die Erfindung ist nicht auf eine der vorbeschriebenen Ausführungsformen beschränkt, sondern in vielfältiger Weise abwandelbar.

Sämtliche aus den Ansprüchen, der Beschreibung und der Zeichnung hervorgehenden Merkmale und Vorteile, einschließlich konstruktiver Einzelheiten, räumlicher Anordnungen und Verfahrensschritten, können sowohl für sich als auch in den verschiedensten Kombinationen erfindungswesentlich sein.

**Bezugszeichenliste**

| | |
|---|---|
| 2 | Laserdioden-Anordnung |
| 4 | Laserdiode |
| 6 | Frontfacette |
| 8 | Rückfacette |
| 10 | externer Resonator |

| | |
|---|---|
| 12 | Resonatorspiegel |
| 14 | wellenlängenselektives optisches Reflexionselement / Beugungsgitter |
| 16 | Schwenkachse |
| 18 | Laserstrahl zwischen Frontfacette und Resonatorspiegel |
| 20 | beugende Oberfläche |
| 22 | erste Beugungsordnung / Laserstrahl |
| 24 | ausgekoppelter Laserstrahl |
| 26 | erste Kollimationslinse |
| 28 | zweite Kollimationslinse |
| 30 | Spiegelfläche |
| 32 | kreisrunde Fläche |
| 34 | Aktuatorabschnitt |
| 36 | Aktuatorabschnitt |
| 40 | Treffpunkt Laserstrahl auf Spiegelfläche |
| 42 | Träger |
| $\gamma$, $\gamma_{-2}$, $\gamma_{-1}$, $\gamma_0$, $\gamma_{+1}$, $\gamma_{+2}$ | erster Einfallswinkel / Einfallswinkel des emittierten Laserstrahls auf die Spiegelfläche |
| $\varphi$, $\varphi_{-2}$, $\varphi_{-1}$, $\varphi_0$, $\varphi_{+1}$, $\varphi_{+2}$ | zweiter Einfallswinkel / Einfallswinkel des von der Spiegelfläche reflektierten Laserstrahls auf beugende Oberfläche |
| $a_{-2}$, $a_0$, $a_{+2}$ | Abstand zwischen der ersten Schwenkachse nächstgelegenen Linie und Treffpunkt des Laserstahls auf die Spiegelfläche |
| $d_{-2}$, $d_{-1}$, $d_0$, $d_{+1}$, $d_{+2}$ | Optische Wegstrecke zwischen Spiegelfläche und beugender Oberfläche |
| $\delta_{-2}$, $\delta_{+2}$ | Änderung der optischen Länge des Laserstrahls zwischen Frontfacette und Resonatorspiegel bei Änderung des Einfallswinkels auf Spiegelfläche |

**Patentansprüche**

1. Laserdioden-Anordnung (2) zum Erzeugen einmodiger, durchstimmbarer Laserstrahlung, aufweisend:

   - eine Laserdiode (4) und
   - einen daran angekoppelten externen Resonator (10), der einen Resonatorspiegel (12) und mindestens ein wellenlängenselektives optisches Reflexionselement (14) mit einer beugenden Oberfläche (20) aufweist,
   - wobei der Resonatorspiegel (12) um eine Schwenkachse (16) drehbar gelagert ist und mittels einer Auslenkvorrichtung selektiv um die Schwenkachse (16) verdrehbar ist,

   wobei

   a) der externe Resonator (10) dazu ausgebildet ist, dass ein von der Laserdiode (4) in den externen Resonator (10) emittierter Laserstrahl (18) unter einem von der Drehung des Resonatorspiegels (12) abhängigen ersten Einfallswinkel ($\gamma$) auf eine Spiegelfläche (30) des Resonatorspiegels (12) trifft und von diesem auf das mindestens eine wellenlängenselektive optische Reflexionselement (14) unter einem von dem ersten Einfallswinkel ($\gamma$) abhängigen zweiten Einfallswinkel ($\varphi$) reflektiert wird,
   b) wobei eine optische Wegstrecke ($d$) zwischen dem Resonatorspiegel (12) und der beugenden Oberfläche (20) durch den ersten Einfallswinkel ($\gamma$) beeinflusst wird, und
   c) wobei das wellenlängenselektive optische Reflexionselement (14) den Laserstrahl gebeugt zurück auf den Resonatorspiegel (12) reflektiert, so dass er von dem Resonatorspiegel (12) zurück in die Laserdiode (4) geleitet wird,
   d) wobei die Wellenlänge des von dem wellenlängenselektiven Reflexionselement (14) reflektierten Laserstrahls durch den zweiten Einfallswinkel ($\varphi$) beeinflusst wird,
   e) wobei die Schwenkachse (16) an einer von der Laserdiode (4) abgewandten Seite des Resonatorspiegels (12) in einem Abstand zu der Spiegelfläche (30) positioniert ist, **dadurch gekennzeichnet,**
   f) **dass** ein Abstand ($a_{-2}$, $a_0$, $a_{+2}$) zwischen einer der Schwenkachse (16) des Resonatorspiegels (12) am nächsten gelegenen Linie auf der Spiegelfläche (30) und einem Treffpunkt (40) des gesamten Laserstahls (18) auf der Spiegelfläche (30) stets größer als 0 ist.

2. Laserdioden-Anordnung (2) nach Anspruch 1, wobei sich die optische Wegstrecke ($d$) zwischen dem Resonatorspiegel (12) und der beugenden Oberfläche (20) mit zunehmendem ersten Einfallswinkel ($\gamma$) vergrößert.

3. Laserdioden-Anordnung (2) nach Anspruch 1 oder 2, wobei sich die Wellenlänge des von dem wellenlängenselektiven Reflexionselement (14) reflektierten Laserstrahls mit zunehmendem ersten Einfallswinkel (γ) vergrößert.

4. Laserdioden-Anordnung (2) nach einem der vorhergehenden Ansprüche, wobei die Laserdiode (4) eine Rückfacette (8) und eine dem externen Resonator (10) zugewandte und mit einer Antireflexionsschicht versehene Frontfacette (6) aufweist.

5. Laserdioden-Anordnung (2) nach einem der vorhergehenden Ansprüche, wobei das mindestens eine wellenlängenselektive optische Reflexionselement (14) ein optisches Beugungsgitter ist.

6. Laserdioden-Anordnung (2) nach einem der vorhergehenden Ansprüche, ferner aufweisend mindestens eine optische Transmissionskomponente (26) zwischen dem Resonatorspiegel (12) und der Laserdiode (4).

7. Laserdioden-Anordnung (2) nach Anspruch 6, wobei die mindestens eine optische Transmissionskomponente (26) einen Kollimator (26) umfasst.

8. Laserdioden-Anordnung (2) nach einem der vorhergehenden Ansprüche, wobei an einer der Laserdiode (4) abgewandten Seite der Rückfacette (8) ein Kollimator (28) angeordnet ist.

9. Laserdioden-Anordnung (2) nach einem der vorhergehenden Ansprüche, wobei das mindestens eine wellenlängenselektive Reflexionselement (14) schräg zu einer Abstrahlrichtung des von der Laserdiode (4) emittierten Laserstrahls (18) angeordnet ist, wobei die beugende Oberfläche (20) von der Laserdiode (4) abgewandt ist.

10. Laserdioden-Anordnung (2) nach einem der vorhergehenden Ansprüche, wobei der Resonatorspiegel (12) schräg zu einer Abstrahlrichtung des von der Laserdiode (4) emittierten Laserstrahls (18) angeordnet ist, wobei die Spiegelfläche (30) der Laserdiode (4) zugewandt ist.

11. Laserdioden-Anordnung (2) nach einem der vorhergehenden Ansprüche, wobei der Resonatorspiegel (12) derart bewegbar ist, dass zumindest in einer Position des Resonatorspiegels (12) und des wellenlängenselektiven Reflexionselements (14) der Resonatorspiegel (12) parallel zu dem wellenlängenselektiven Reflexionselement (14) ausgerichtet ist.

12. Laserdioden-Anordnung (2) nach einem der vorhergehenden Ansprüche, wobei die Laserdioden-Anordnung (2) als ein mikromechanisches System gefertigt ist.

## Claims

1. Laser diode arrangement (2) for generating single-mode tunable laser radiation, having:

   - a laser diode (4) and
   - an external resonator (10) coupled thereto, said external resonator having a resonator mirror (12) and at least one wavelength-selective optical reflection element (14) having a diffractive surface (20),
   - wherein the resonator mirror (12) is mounted so as to be able to rotate about a swivel axis (16) and is able to be turned selectively about the swivel axis (16) by way of a deflection device,

   wherein

   a) the external resonator (10) is designed such that a laser beam (18) emitted by the laser diode (4) into the external resonator (10) impinges on a mirror surface (30) of the resonator mirror (12) at a first angle of incidence (γ) dependent on the rotation of the resonator mirror (12) and is reflected thereby onto the at least one wavelength-selective optical reflection element (14) at a second angle of incidence (φ) dependent on the first angle of incidence (γ),
   b) wherein an optical path (d) between the resonator mirror (12) and the diffractive surface (20) is influenced by the first angle of incidence (γ), and
   c) wherein the wavelength-selective optical reflection element (14) reflects the laser beam in diffracted form back onto the resonator mirror (12) such that it is guided from the resonator mirror (12) back into the laser diode (4),
   d) wherein the wavelength of the laser beam reflected by the wavelength-selective reflection element (14) is influenced by the second angle of incidence (φ),

e) wherein the swivel axis (16) is positioned on a side of the resonator mirror (12) that faces away from the laser diode (4) at a distance from the mirror surface (30), **characterized in that**

f) a distance ($a_{-2}$, $a_0$, $a_{+2}$) between a line, closest to the swivel axis (16) of the resonator mirror (12), on the mirror surface (30) and a point of incidence (40) of the overall laser beam (18) on the mirror surface (30) is always greater than 0.

2. Laser diode arrangement (2) according to Claim 1, wherein the optical path (d) between the resonator mirror (12) and the diffractive surface (20) increases as the first angle of incidence ($\gamma$) increases.

3. Laser diode arrangement (2) according to Claim 1 or 2, wherein the wavelength of the laser beam reflected by the wavelength-selective reflection element (14) increases as the first angle of incidence ($\gamma$) increases.

4. Laser diode arrangement (2) according to one of the preceding claims, wherein the laser diode (4) has a rear facet (8) and a front facet (6) that faces the external resonator (10) and that is provided with an antireflection layer.

5. Laser diode arrangement (2) according to one of the preceding claims, wherein the at least one wavelength-selective optical reflection element (14) is an optical diffraction grating.

6. Laser diode arrangement (2) according to one of the preceding claims, furthermore having at least one optical transmission component (26) between the resonator mirror (12) and the laser diode (4).

7. Laser diode arrangement (2) according to Claim 6, wherein the at least one optical transmission component (26) comprises a collimator (26).

8. Laser diode arrangement (2) according to one of the preceding claims, wherein a collimator (28) is arranged on a side of the rear facet (8) that faces away from the laser diode (4).

9. Laser diode arrangement (2) according to one of the preceding claims, wherein the at least one wavelength-selective reflection element (14) is arranged obliquely with respect to an emission direction of the laser beam (18) emitted by the laser diode (4), wherein the diffractive surface (20) faces away from the laser diode (4).

10. Laser diode arrangement (2) according to one of the preceding claims, wherein the resonator mirror (12) is arranged obliquely with respect to an emission direction of the laser beam (18) emitted by the laser diode (4), wherein the mirror surface (30) faces the laser diode (4).

11. Laser diode arrangement (2) according to one of the preceding claims, wherein the resonator mirror (12) is able to be moved such that, at least in one position of the resonator mirror (12) and of the wavelength-selective reflection element (14), the resonator mirror (12) is aligned parallel with the wavelength-selective reflection element (14).

12. Laser diode arrangement (2) according to one of the preceding claims, wherein the laser diode arrangement (2) is produced as a micromechanical system.

**Revendications**

1. Système de diode laser (2) destiné à produire un rayonnement laser monomode accordable, comportant :

- une diode laser (4) et
- un résonateur externe (10) couplé à celle-ci, qui comporte un miroir de résonateur (12) et au moins un élément de réflexion optique sélectif en longueur d'onde (14) pourvu d'une surface de diffraction (20),
- le miroir de résonateur (12) étant monté de manière à pouvoir tourner autour d'un axe de pivotement (16) et pouvant tourner sélectivement autour de l'axe de pivotement (16) au moyen d'un dispositif de déviation,

dans lequel

a) le résonateur externe (10) est conçu pour qu'un rayon laser (18) émis par la diode laser (4) dans le résonateur externe (10) arrive sur une surface de miroir (30) du miroir de résonateur (12) sous un premier angle d'incidence ($\gamma$) dépendant de la rotation du miroir de résonateur (12) et soit réfléchi par ce dernier sur ledit au moins un élément de réflexion optique sélectif en longueur d'onde (14) sous un deuxième angle d'incidence (φ) dépendant du premier angle d'incidence (γ),

b) un trajet optique (d) entre le miroir de résonateur (12) et la surface de diffraction (20) étant influencé par le premier angle d'incidence (γ), et

c) l'élément de réflexion optique sélectif en longueur d'onde (14) réfléchissant le rayon laser de manière diffractée en retour sur le miroir de résonateur (12), de manière à ce qu'il soit guidé par le miroir de résonateur (12) en retour vers la diode laser (4),

d) la longueur d'onde du rayon laser réfléchi par l'élément de réflexion sélectif en longueur d'onde (14) étant influencée par le deuxième angle d'incidence (φ),

e) l'axe de pivotement (16) étant positionné sur un côté du miroir résonateur (12) qui est tourné à l'opposé de la diode laser (4) à une certaine distance de la surface de miroir (30), **caractérisé en ce que**

f) une distance ($a_{-2}$, $a_0$, $a_{+2}$) entre une ligne de la surface de miroir (30) la plus proche de l'axe de pivotement (16) du miroir de résonateur (12) et un point d'incidence (40) de l'ensemble du rayon laser (18) sur la surface de miroir (30) est toujours supérieure à 0.

2. Système de diode laser (2) selon la revendication 1, dans lequel la distance optique (d) entre le miroir de résonateur (12) et la surface de diffraction (20) augmente lorsque le premier angle d'incidence (γ) augmente.

3. Système de diode laser (2) selon la revendication 1 ou 2, dans lequel la longueur d'onde du rayon laser réfléchi par l'élément de réflexion sélectif en longueur d'onde (14) augmente lorsque le premier angle d'incidence (γ) augmente.

4. Système de diode laser (2) selon l'une des revendications précédentes, dans lequel la diode laser (4) présente une facette arrière (8) et une facette avant (6) tournée vers le résonateur externe (10) et pourvue d'une couche antiréfléchissante.

5. Système de diode laser (2) selon l'une des revendications précédentes, dans lequel ledit au moins un élément de réflexion optique sélectif en longueur d'onde (14) est un réseau de diffraction optique.

6. Système de diode laser (2) selon l'une des revendications précédentes, comportant en outre au moins un composant de transmission optique (26) entre le miroir de résonateur (12) et la diode laser (4).

7. Système de diode laser (2) selon la revendication 6, dans lequel ledit au moins un composant de transmission optique (26) comprend un collimateur (26).

8. Système de diode laser (2) selon l'une des revendications précédentes, dans lequel un collimateur (28) est disposé sur un côté de la facette arrière (8) qui est tourné à l'opposé de la diode laser (4).

9. Système de diode laser (2) selon l'une des revendications précédentes, dans lequel ledit au moins un élément de réflexion sélectif en longueur d'onde (14) est disposé de manière oblique par rapport à une direction de rayonnement du rayon laser (18) émis par la diode laser (4), la surface de diffraction (20) étant tournée à l'opposé de la diode laser (4).

10. Système de diode laser (2) selon l'une des revendications précédentes, dans lequel le miroir de résonateur (12) est disposé de manière oblique par rapport à une direction de rayonnement du rayon laser (18) émis par la diode laser (4), la surface de miroir (30) étant tournée vers la diode laser (4).

11. Système de diode laser (2) selon l'une des revendications précédentes, dans lequel le miroir de résonateur (12) est mobile de manière à ce que, dans au moins une position du miroir de résonateur (12) et de l'élément de réflexion sélectif en longueur d'onde (14), le miroir de résonateur (12) soit orienté parallèlement à l'élément de réflexion sélectif en longueur d'onde (14).

12. Système de diode laser (2) selon l'une des revendications précédentes, dans lequel le système de diode laser (2) est fabriqué sous la forme d'un système micromécanique.

# Fig. 1

Fig. 2

Fig. 3a

Fig. 3b

Fig. 3c

Fig. 4a

Fig. 4b

**Fig. 4c**

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102014201701 A1
- US 5956355 A